(19) Europäisches Patentamt / European Patent Office / Office européen des brevets

(11) **EP 3 745 473 B1**

(12) **FASCICULE DE BREVET EUROPEEN**

(45) Date de publication et mention de la délivrance du brevet:
**08.09.2021 Bulletin 2021/36**

(51) Int Cl.:
*H01L 33/10* (2010.01)      *H01L 33/24* (2010.01)
*H01S 5/30* (2006.01)      *H01L 33/34* (2010.01)
*H01S 5/125* (2006.01)

(21) Numéro de dépôt: **20173254.2**

(22) Date de dépôt: **06.05.2020**

(54) **DISPOSITIF OPTOELECTRONIQUE COMPORTANT UNE PORTION CENTRALE CONTRAINTE EN TENSION SUIVANT UN PREMIER AXE ET POLARISEE ELECTRIQUEMENT SUIVANT UN DEUXIEME AXE**

OPTOELEKTRONISCHE VORRICHTUNG, DIE EINEN ZENTRALEN ABSCHNITT UMFASST, DER ENTLANG EINER ERSTEN ACHSE SPANNUNGSBELASTET IST UND ENTLANG EINER ZWEITEN ACHSE ELEKTRISCH POLARISIERT IST

OPTOELECTRONIC DEVICE COMPRISING A CENTRAL PORTION STRESSED BY TENSIONING ACCORDING TO A FIRST AXIS AND ELECTRICALLY POLARISED ACCORDING TO A SECOND AXIS

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **09.05.2019 FR 1904820**

(43) Date de publication de la demande:
**02.12.2020 Bulletin 2020/49**

(73) Titulaire: **COMMISSARIAT À L'ÉNERGIE ATOMIQUE ET AUX ÉNERGIES ALTERNATIVES**
**75015 Paris (FR)**

(72) Inventeurs:
• **REBOUD, Vincent**
  **38054 Grenoble cedex 09 (FR)**
• **BERTRAND, Mathieu**
  **38054 Grenoble cedex 09 (FR)**
• **PAUC, Nicolas**
  **38054 Grenoble cedex 09 (FR)**
• **TCHELNOKOV, Alexei**
  **38054 Grenoble cedex 09 (FR)**

(74) Mandataire: **INNOV-GROUP**
  **310, avenue Berthelot**
  **69372 Lyon Cedex 08 (FR)**

(56) Documents cités:
**EP-A1- 3 447 549**

• **JIALIN JIANG ET AL: "Strain-Induced Enhancement of Electroluminescence from Highly Strained Germanium Light-Emitting Diodes", ACS PHOTONICS, vol. 6, no. 4, 20 mars 2019 (2019-03-20), pages 915-923, XP055655555, ISSN: 2330-4022, DOI: 10.1021/acsphotonics.8b01553**

# Description

## DOMAINE TECHNIQUE

Le domaine de l'invention est celui des dispositifs optoélectroniques d'émission ou de détection d'un rayonnement lumineux, tels que les diodes lasers, les diodes électroluminescentes et les photodiodes, comportant une portion centrale mise en contrainte par des bras tenseurs. L'invention trouve une application dans les circuits intégrés photoniques, notamment dans le cadre de la technologie dite photonique sur silicium.

## ÉTAT DE LA TECHNIQUE ANTÉRIEURE

Dans diverses applications microélectroniques ou optoélectroniques, il peut être avantageux d'utiliser une couche semiconductrice en un matériau cristallin, de préférence monocristallin, présentant localement une contrainte mécanique en tension. C'est le cas notamment de certaines sources de lumière dont le matériau d'amplification optique présente, hors contrainte, une structure de bandes d'énergie indirecte, la structure de bandes étant alors rendue directe par l'application d'une contrainte en tension suffisante. Le matériau semiconducteur cristallin peut être un matériau à base de germanium, par exemple peut être du germanium, du germanium étain, voire du silicium germanium.

L'article de Petykiewicz et al. intitulé Direct Bandgap Light Emission from Strained Ge Nanowires, Nano Lett., 2016, 16 (4), 2168-2173, décrit un exemple de source laser comportant une couche semiconductrice réalisée à base de germanium, la couche semiconductrice étant structurée pour former une membrane suspendue au-dessus d'une couche support. La membrane suspendue comporte une portion centrale allongée mise en tension suivant son axe longitudinal par des portions latérales formant des bras tenseurs. La portion centrale comporte une zone active, ici le milieu à gain de la source laser. Cette zone active est située dans une cavité optique définie par deux miroirs de Bragg, lesquels sont disposés dans les bras tenseurs et sont formés par une succession périodique de gravures localisées de la couche semiconductrice. L'émission lumineuse est ici obtenue par pompage optique du milieu à gain.

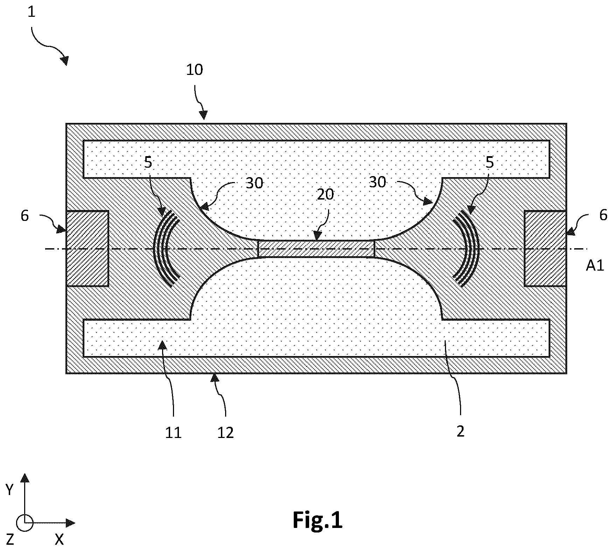

La figure 1 illustre un exemple de dispositif optoélectronique 1 similaire à celui décrit dans l'article de Petykiewicz et al. 2016, dans lequel le pompage du milieu à gain (zone active) est effectué de manière électrique. La partie structurée 11 (membrane suspendue) de la couche semiconductrice 10 comporte ainsi une portion centrale 20 allongée, et mise en tension par des bras tenseurs 30 suivant l'axe longitudinal A1. Les bras tenseurs 30 et la portion centrale 20 forment donc la partie structurée 11 de la couche semiconductrice, qui est suspendue au-dessus d'une couche support 2 et est reliée à une partie périphérique 12 de la couche semiconductrice. La cavité optique est définie par des miroirs de Bragg 5 situés dans les bras tenseurs 30, et est donc orientée suivant l'axe longitudinal A1. Par ailleurs, dans le but d'effectuer le pompage électrique du milieu à gain, les bras tenseurs 30 sont en contact électrique avec des plots de connexion 6 qui permettent de polariser électriquement du milieu à gain, de sorte que les porteurs de charge sont injectés dans la portion centrale 20 à partir des plots de connexion via les bras tenseurs 30.

EP 3 447 549 A1 divulgue un autre dispositif optoélectronique similaire, comprenant deux bras tenseurs et deux bras de polarisation disposés selon un axe orthogonal aux bras tenseurs.

Cependant, il existe un besoin de disposer d'un dispositif optoélectronique identique ou similaire, dont les propriétés optiques et/ou électroniques sont optimisées. Par ailleurs, il apparaît que les propriétés optiques et/ou électroniques d'un tel dispositif optoélectronique dépendent notamment de celles de la zone active située dans la portion centrale, lesquelles peuvent être impactées par le type de procédé de fabrication du dispositif optoélectronique mis en œuvre. Aussi, il existe un besoin de disposer d'un tel dispositif optoélectronique dont les propriétés optiques et/ou électroniques sont moins dépendantes du type de procédé de fabrication mis en œuvre.

## EXPOSÉ DE L'INVENTION

L'invention a pour objectif de remédier au moins en partie aux inconvénients de l'art antérieur, et plus particulièrement de proposer un dispositif optoélectronique à portion centrale allongée, laquelle est mise en tension par des bras tenseurs, dont les propriétés optiques et/ou électroniques sont optimisées. L'invention a également pour objectif de proposer un dispositif optoélectronique dont la portion centrale allongée comporte une zone active polarisée électriquement, dont la polarisation électrique est sensiblement homogène suivant l'axe longitudinal de la portion centrale.

Pour cela, l'objet de l'invention est un dispositif optoélectronique comportant une couche semiconductrice réalisée à base d'un matériau semiconducteur cristallin, laquelle comporte : une portion centrale présentant une forme allongée suivant un axe longitudinal, contrainte en tension suivant l'axe longitudinal, et comportant une zone active d'émission ou de détection d'un rayonnement lumineux ; ainsi que au moins deux premières portions latérales formant des bras tenseurs, opposés l'un à l'autre vis-à-vis de la portion centrale suivant l'axe longitudinal, et s'étendant à partir de la portion centrale, présentant une largeur moyenne supérieure à une largeur moyenne de la portion centrale, de manière à contraindre en tension la portion centrale suivant l'axe longitudinal ; et au moins deux plots de connexion, adaptés à appliquer une polarisation électrique à la portion centrale.

Selon l'invention, la couche semiconductrice comporte en outre au moins deux deuxièmes portions latérales formant des bras de polarisation, opposés l'un à l'autre vis-à-vis de la portion centrale suivant un axe transversal orienté de manière orthogonale à l'axe longitudinal, et s'étendant à partir de la portion centrale, chacun étant formé : d'une partie principale, en contact électrique avec l'un des plots de connexion, les parties principales des bras de polarisation étant dopées selon des types de conductivité opposés ; et d'une pluralité de parties de raccord reliant la partie principale à la portion centrale.

Certains aspects préférés mais non limitatifs de ce dispositif optoélectronique sont les suivants.

Le matériau semiconducteur cristallin dans les bras tenseurs est de préférence intrinsèque.

Le dispositif optoélectronique peut être adapté à émettre un rayonnement lumineux à une longueur d'onde À. Les parties de raccord peuvent être agencées suivant l'axe longitudinal de manière périodique, la période p de l'agencement des parties de raccord suivant l'axe longitudinal étant inférieure à la longueur d'onde À.

Un rapport de la largeur des parties de raccord suivant l'axe longitudinal sur une distance séparant deux parties de raccord adjacentes suivant l'axe longitudinal, et le rapport de la période p sur la longueur d'onde À, peuvent être tels que les parties de raccord forment des réflecteurs optiques définissant une cavité optique vis-à-vis d'un mode optique de longueur d'onde $\lambda$ supporté par la portion centrale.

Les parties de raccord peuvent présenter une jonction courbée avec la portion centrale, avec un rayon de courbure égal, à 10% près, à la moitié d'une distance séparant deux parties de raccord adjacentes suivant l'axe longitudinal.

Les bras de polarisation peuvent comporter chacun : une partie continue, distincte de la portion centrale, s'étendant longitudinalement suivant l'axe longitudinal, et reliant les parties de raccord entre elles ; et au moins une partie intermédiaire reliant la partie principale à la partie continue, la partie intermédiaire présentant une longueur et une largeur inférieures à celles de la partie principale correspondante, de sorte que les bras de polarisation induisent dans la portion centrale une contrainte en tension orientée suivant l'axe transversal.

La portion centrale peut présenter une structure de bandes d'énergie directe.

La couche semiconductrice peut être réalisée à base de germanium.

Les plots de connexion peuvent reposer sur et au contact des parties principales des bras de polarisation.

La couche semiconductrice peut comporter une partie dite structurée et une partie dite périphérique, la partie structurée étant formée de la portion centrale, des bras tenseurs et des bras de polarisation, la partie structurée étant une membrane suspendue au-dessus d'une couche support, ou étant au contact de la couche support et distincte de celle-ci dans un plan parallèle à la couche support.

La couche semiconductrice peut comporter des tranchées traversantes, s'étendant entre les plots de connexion et la partie périphérique.

## BRÈVE DESCRIPTION DES DESSINS

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence aux dessins annexés sur lesquels :

la figure 1, déjà décrite, est une vue de dessus, schématique et partielle, d'un exemple de dispositif optoélectronique d'émission d'une lumière cohérente dans lequel le pompage électrique de la zone active (milieu à gain) est effectué par le biais des bras tenseurs ;

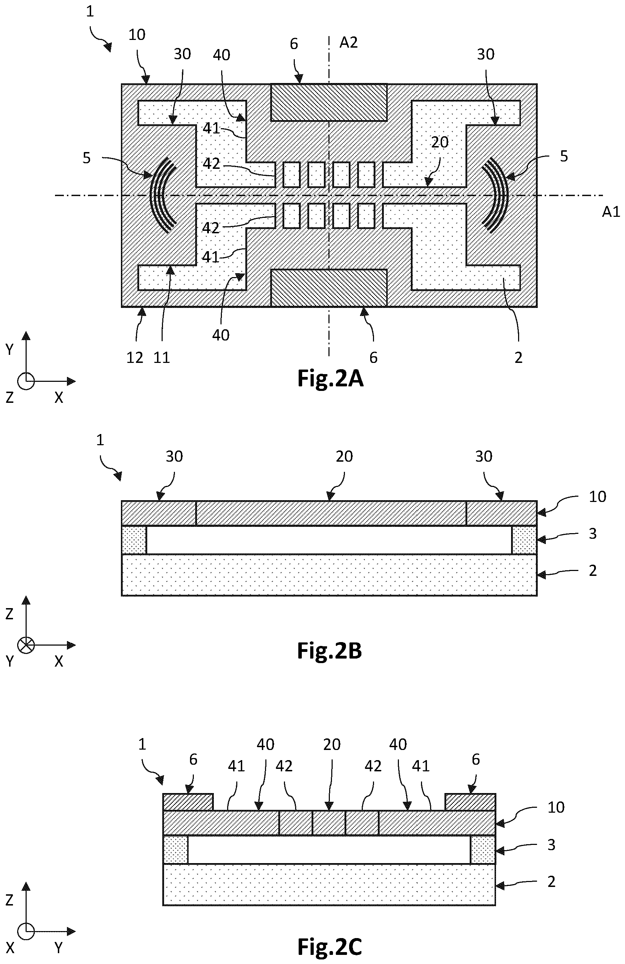

les figures 2A à 2C sont des vues schématiques et partielles, respectivement en vue de dessus, en coupe suivant l'axe longitudinal A1 et en coupe suivant l'axe transversal A2, d'un dispositif optoélectronique d'émission de lumière cohérente selon un mode de réalisation dans lequel la portion centrale est suspendue au-dessus d'une couche support ;

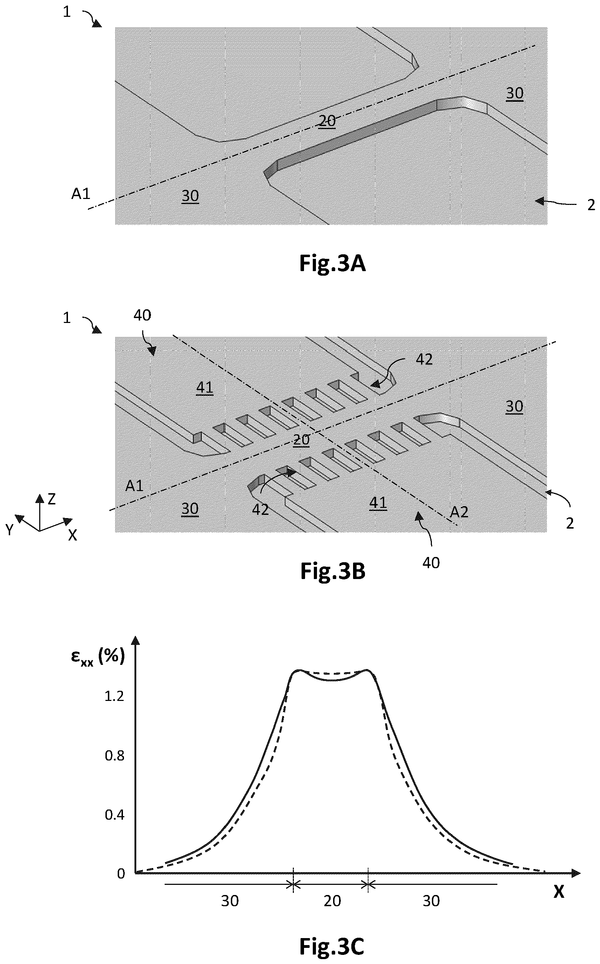

les figures 3A et 3B sont des vues schématiques et partielles, et en perspective, d'un dispositif optoélectronique selon un exemple de l'art antérieur (fig.3A) et d'un dispositif optoélectronique selon un mode de réalisation (fig.3B), et la figure 3C illustre l'évolution de la contrainte mécanique $\varepsilon_{xx}$, orientée suivant l'axe longitudinal A1, subie par la portion centrale et par les bras tenseurs, pour les deux dispositifs optoélectroniques illustrés sur ces fig.3A et 3B ;

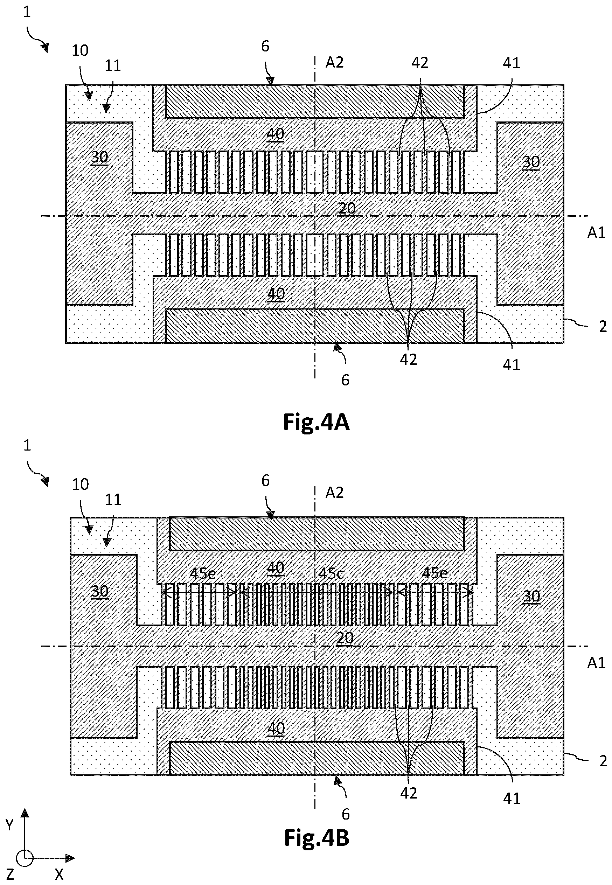

les figures 4A et 4B sont des vues de dessus, schématiques et partielles, de dispositifs optoélectroniques d'émission d'une lumière cohérente selon différents modes de réalisation dans lesquels la cavité optique est définie par les parties de raccord des bras de polarisation ;

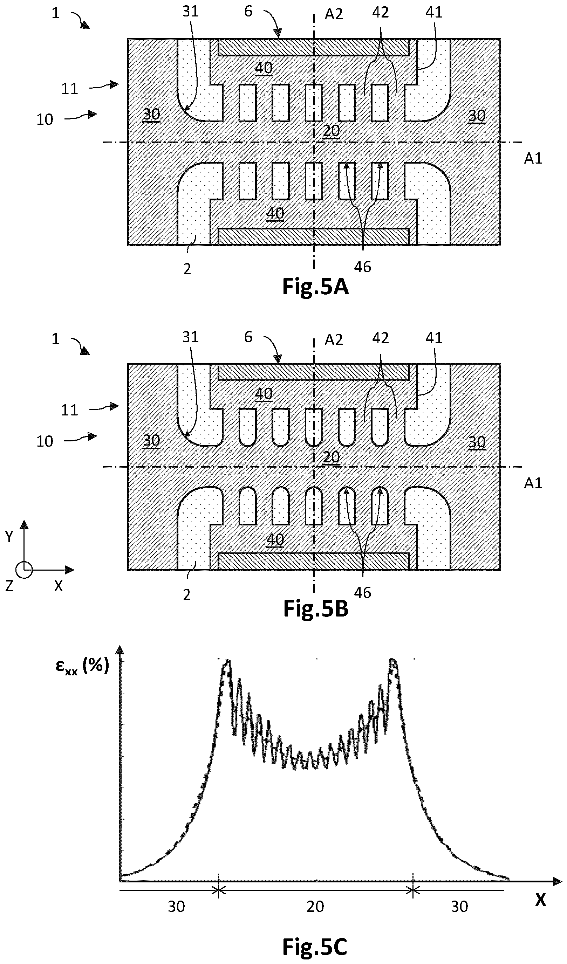

les figures 5A et 5B sont des vues en perspective, schématiques et partielles, d'un dispositif optoélectronique selon un mode de réalisation dont la jonction entre les parties de raccord et la portion centrale est sensiblement orthogonale (fig.5A) et d'un dispositif optoélectronique selon un autre mode de réalisation dont la jonction entre ces éléments est courbée (fig.5B), et la figure 5C illustre l'évolution de la contrainte mécanique $\varepsilon_{xx}$, orientée suivant l'axe longitudinal A1, subie par la portion centrale et par les bras tenseurs, pour les deux dispositifs optoélectroniques illustrés sur ces fig.5A et 5B ;

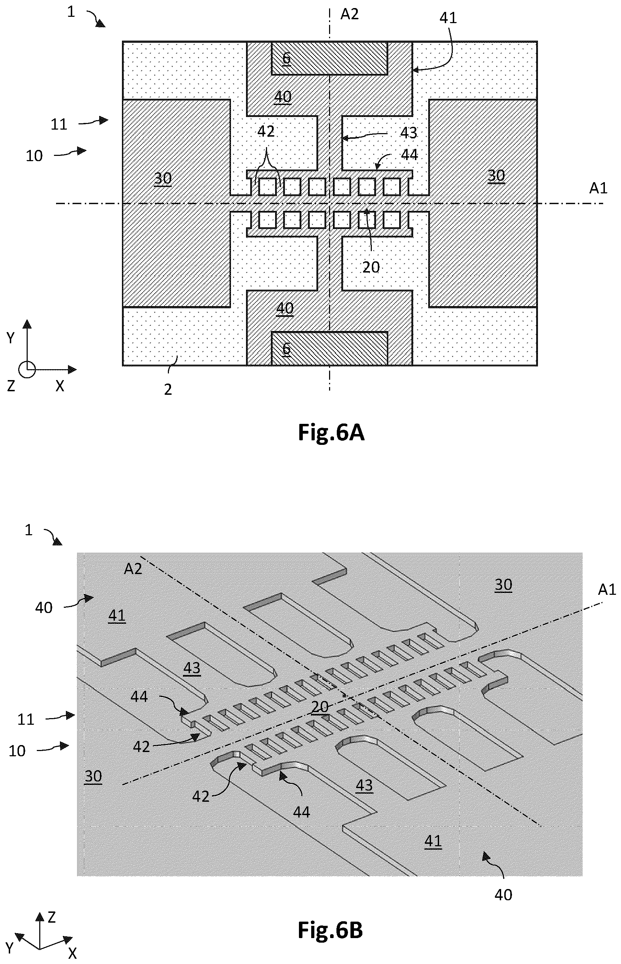

les figures 6A et 6B sont des vues schématiques et partielles, respectivement de dessus et en perspective, de dispositifs optoélectroniques selon différents modes de réalisation, dans lesquels les bras de polarisation sont adaptés à induire une mise en tension de la portion centrale suivant l'axe transversal A2 ;

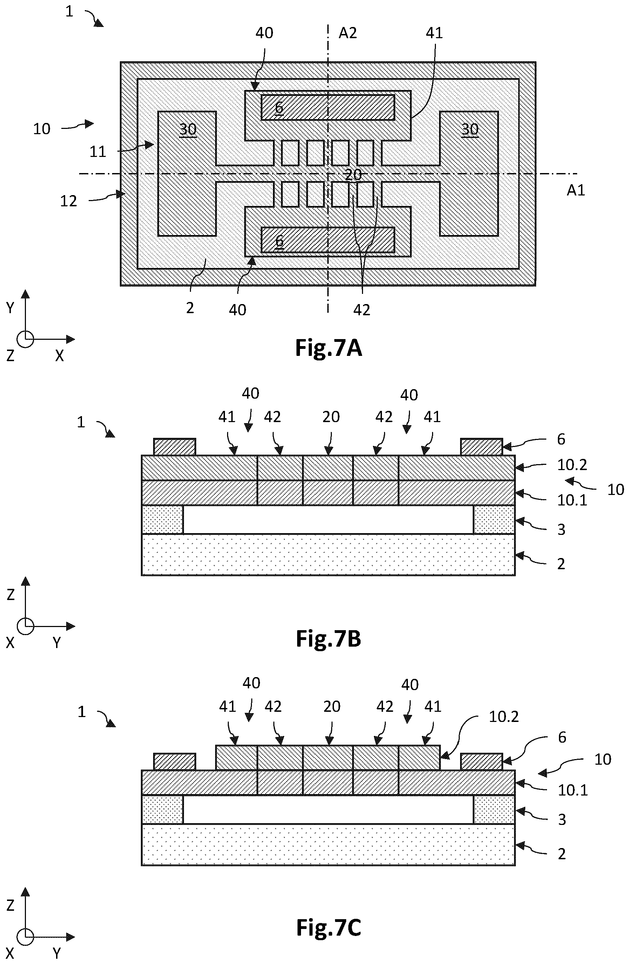

les figures 7A à 7C sont des vues schématiques et partielles de dispositifs optoélectroniques selon différents modes de réalisation.

## EXPOSÉ DÉTAILLÉ DE MODES DE RÉALISATION PARTICULIERS

Sur les figures et dans la suite de la description, les mêmes références représentent les éléments identiques ou similaires. De plus, les différents éléments ne sont pas représentés à l'échelle de manière à privilégier la clarté des figures. Par ailleurs, les différents modes de réalisation et variantes ne sont pas exclusifs les uns des autres et peuvent être combinés entre eux. Sauf indication contraire, les termes « sensiblement », « environ », « de l'ordre de » signifient à 10% près, et de préférence à 5% près. Par ailleurs, les termes « compris entre ... et ... » et équivalents signifient que les bornes sont incluses, sauf mention contraire.

L'invention porte sur un dispositif optoélectronique d'émission ou de détection d'un rayonnement lumineux, par exemple une diode laser, une diode électroluminescente, ou un photodétecteur, comportant une couche semiconductrice formée de :

 ◦ une portion centrale allongée, mise en tension suivant son axe longitudinal A1, et comportant une zone active adaptée à émettre ou à détecter un rayonnement lumineux d'intérêt ;
 ◦ des bras tenseurs, assurant une mise en tension de la portion centrale suivant l'axe longitudinal A1 de cette dernière ; et
 ◦ des bras de polarisation électrique, adaptés à assurer la polarisation électrique de la zone active suivant un axe transversal A2 de la portion centrale, chaque bras de polarisation étant formé :

  • d'une partie dite principale, laquelle est en contact électrique avec un plot de connexion, les parties principales des bras de polarisation étant dopées selon des types de conductivité opposés,
  • d'une pluralité de parties dite de raccord, qui relient la partie principale à la portion centrale.

D'une manière générale, la couche semiconductrice est réalisée en au moins un matériau semiconducteur cristallin, lequel est de préférence monocristallin. Il peut être choisi notamment parmi les éléments de la colonne IV de la classification périodique, tels que le germanium Ge, le silicium Si, l'étain Sn dans sa phase semiconductrice, et parmi les composés formés de ces éléments, par exemple le GeSn, le SiGeSn, et le SiGe. Il peut également être choisi parmi les composés III-V comportant des éléments des colonnes III et V de la classification périodique, comme par exemple le GaInAs et l'InP, voire parmi les composés II-VI comportant des éléments des colonnes II et VI, comme par exemple le CdHgTe.

De préférence, la couche semiconductrice est réalisée à base d'un matériau semiconducteur d'intérêt dont la structure de bandes d'énergie, en l'absence de déformation en tension suffisante de son réseau cristallin est indirecte. La déformation en tension subie par le matériau semiconducteur de la couche semiconductrice au niveau de la portion centrale peut alors être suffisante pour que sa structure de bandes soit sensiblement directe. La couche semiconductrice est ici de préférence réalisée à base de germanium. Par réalisée à base germanium, on entend que la couche semiconductrice est formée majoritairement en germanium ou en ses composés.

Par portion contrainte, on entend une portion de la couche semiconductrice présentant une contrainte mécanique en tension ou en compression, entraînant une déformation des mailles de son réseau cristallin. La portion est contrainte en tension lorsqu'elle subit une contrainte mécanique qui tend à étirer les mailles du réseau dans un plan. Dans le cadre de l'invention, la portion centrale de la couche semiconductrice est contrainte en tension dans le plan de la couche, ce qui se traduit par le fait que son paramètre de maille présente une valeur dite effective supérieure à sa valeur naturelle lorsque le matériau semiconducteur est relaxé (i.e. non contraint). Dans la suite de la description, sauf indication contraire, la contrainte considérée est orientée dans le plan de la couche semiconductrice.

Par structure de bandes directe ou sensiblement directe, on entend que le minimum d'énergie $E_{BC,L}$ de la bande de conduction de la vallée L (ou vallée indirecte) est supérieur ou sensiblement égal au minimum d'énergie $E_{BC,\Gamma}$ de la bande de conduction de la vallée $\Gamma$ (ou vallée directe), autrement dit : $\Delta E = E_{BC,L} - E_{BC,\Gamma} \geq 0$. Par sensiblement égal, on entend ici que cette différence d'énergie est de l'ordre de grandeur ou inférieure à kT, où k est la constante de Boltzmann et T la température du matériau. La couche semiconductrice est de préférence réalisée à base de germanium dont la structure de bandes d'énergie est indirecte en-dehors de la portion centrale, autrement dit $\Delta E < 0$, et la portion centrale présente une déformation en tension suffisante pour, de préférence, rendre sa structure de bandes d'énergie directe au moins localement.

Les figures 2A à 2C sont des vues partielles et schématiques, respectivement en vue de dessus, en coupe transversale suivant l'axe A1, et en coupe transversale suivant l'axe A2, d'un dispositif optoélectronique 1 selon un mode de réalisation. Le dispositif optoélectronique 1 est ici adapté à émettre un rayonnement lumineux cohérent (diode laser). Comme détaillé ci-dessous, il comporte une cavité optique orientée suivant un axe longitudinal A1 et la zone active du dispositif optoélectronique 1 est polarisée électriquement suivant un axe transversal A2. Dans ce mode de réalisation, la couche semiconductrice 10, réalisée ici à base de germanium, comporte une partie structurée 11 sous la forme d'une membrane suspendue au-dessus d'une couche support 2 (bien que la membrane puisse, en variante, être au contact de la couche support 2).

On définit ici et pour la suite de la description un repère direct tridimensionnel XYZ, où le plan XY est parallèle au plan de la couche semiconductrice 10, où l'axe X est orienté suivant l'axe longitudinal de la portion centrale 20, et où l'axe Z est orienté suivant l'épaisseur de la couche semiconductrice 10. Par ailleurs, les termes « inférieur » et « supérieur » s'entendent comme étant relatifs à un positionnement croissant lorsqu'on s'éloigne d'une couche support 2 suivant la direction Z.

Le dispositif optoélectronique 1 comporte ici un empilement formé d'une couche support 2, d'une couche sacrificielle 3, et d'une couche semiconductrice 10 réalisée à base d'un matériau semiconducteur cristallin, ici à base de germanium. La couche support 2 peut être réalisée en un matériau choisi parmi le silicium, le saphir, le borosilicate, la silice, le verre, le quart, ou tout autre matériau adapté. Elle peut présenter une épaisseur de quelques dizaines de nanomètres à quelques centaines de microns. La couche sacrificielle 3 peut être réalisée en un matériau choisi parmi un oxyde ou un nitrure de silicium, entre autres. Elle peut présenter une épaisseur de l'ordre de quelques dizaines de nanomètres à quelques microns. La couche semiconductrice 10 peut présenter une épaisseur de l'ordre de quelques dizaines de nanomètres à quelques microns, voire davantage, selon les applications électroniques ou optoélectroniques visées. Cet empilement peut, au moins en partie, être issu d'un substrat de type GeOI ou de type SOI. Par ailleurs, la couche support 2 peut comporter des éléments optiques actifs ou passifs, notamment dans le cadre de la technologie dite photonique sur silicium.

D'une manière générale, la couche semiconductrice 10 peut être formée en un même matériau semiconducteur, par exemple en Ge, ou en les mêmes éléments chimiques, par exemple en GeSn dont la proportion atomique en Sn peut varier. En variante, elle peut être formée d'un empilement de différentes sous-couches réalisées à base du matériau semiconducteur d'intérêt, qui se distinguent les unes des autres par les éléments chimiques qui les composent. Ainsi, à titre illustratif, la couche semiconductrice 10 peut être formée d'un empilement d'une sous-couche en GeSn intrinsèque située entre deux sous-couches en Ge dopé selon des types de conductivité opposés, et de sous-couches d'adaptation de maille en SiGeSn situées chacune entre une sous-couche en Ge dopé et la sous-couche en GeSn intrinsèque. Un exemple d'un tel empilement de sous-couches réalisées à base de germanium est décrit notamment dans le document WO2018037189.

Dans ce mode de réalisation, la couche semiconductrice 10 est formée d'une partie structurée 11 suspendue au-dessus de la couche support 2 et d'une partie périphérique 12 qui entoure la partie structurée 11. La partie périphérique 12 repose sur la couche sacrificielle 3, et celle-ci définit dans le plan XY une cavité située sous la partie structurée 11. La partie structurée 11 comporte une portion centrale 20 reliée à la partie périphérique 12 par des premières portions latérales 30 formant des bras tenseurs, et par des deuxièmes portions latérales 40 formant des bras de polarisation électrique.

La portion centrale 20 présente une forme allongée dans le plan XY, dans le sens où elle présente une longueur suivant son axe longitudinal A1 qui est supérieure à sa largeur. La longueur et la largeur sont les dimensions de la portion centrale 20 dans le plan XY. La forme de la portion centrale 20 dans le plan XY peut être rectangulaire, polygonale, oblongue, ou autre. La longueur de la portion centrale 20 peut être de l'ordre de quelques dizaines de microns, et la largeur peut être de l'ordre de quelques microns. Dans le cas où la largeur locale de la portion centrale 20 varie suivant l'axe longitudinal A1, la longueur est alors supérieure à la largeur moyenne (par exemple moyenne arithmétique). La longueur de la portion centrale 20 est la dimension longitudinale de la portion 20 jusqu'à sa jonction avec les bras 30 où la largeur augmente.

La portion centrale 20 comporte une zone dite active, destinée à émettre ou à détecter un rayonnement lumineux d'intérêt. Autrement dit, la zone active s'étend longitudinalement au sein de la portion centrale 20. Elle est formée en au moins un matériau semiconducteur intrinsèque (non intentionnellement dopée) ou peut comporter un ou plusieurs puits quantiques. La zone active présente ici avantageusement une structure de bandes directe ou sensiblement directe. Par ailleurs, elle est destinée à être polarisée électriquement suivant un axe transversal A2, lequel est orthogonal à l'axe longitudinal A1.

La partie structurée 11 de la couche semiconductrice 10 comporte au moins deux premières portions latérales, formant des bras tenseurs 30 opposés l'un à l'autre vis-à-vis de la portion centrale 20 suivant l'axe longitudinal A1.

Ces bras tenseurs 30 sont dimensionnés de manière à induire une déformation en tension dans la portion centrale 20 suivant l'axe longitudinal A1. Ils s'étendent donc longitudinalement à partir de la portion centrale 20, suivant l'axe longitudinal A1, et plus précisément à partir des extrémités longitudinales de cette dernière. Aussi, l'axe longitudinal A1 correspond à un axe de déformation principale de la portion centrale 20. Dans ce mode de réalisation où la partie structurée 11 est une membrane suspendue, les bras tenseurs 30 participent à relier la portion centrale 20 à la partie périphérique 12.

La portion centrale 20 étant contrainte en tension par les bras tenseurs 30, elle présente donc une déformation de sa structure cristallographique par augmentation de son paramètre de maille naturel suivant l'axe longitudinal A1. Les bras tenseurs 30 permettent d'augmenter la valeur initiale non nulle de contrainte en tension dans la portion centrale 20, de préférence sans pour autant subir eux-mêmes une contrainte mécanique significative. Pour cela, comme indiqué plus haut, les bras tenseurs 30 sont dimensionnés de sorte que la largeur moyenne « b » des bras tenseurs 30 est supérieure à la largeur moyenne « a » de la portion centrale 20, de préférence dix fois supérieure à cette dernière. Par largeur, ou largeur locale, on entend la dimension locale d'une portion ou d'un bras, dans le plan XY, suivant un axe transversal A2 orthogonal à l'axe longitudinal A1. La largeur moyenne d'une portion peut alors être une moyenne de sa largeur locale calculée sur la longueur de la portion.

En outre, la dimension surfacique dans le plan XY et la largeur de chaque bras tenseur peuvent être choisies de sorte que les bras tenseurs 30 ne présentent sensiblement pas ou peu de déformation. Plus précisément, la déformation locale dans un bras tenseur diminue à mesure qu'on s'éloigne de la portion centrale 20, et devient négligeable à une distance, suivant l'axe longitudinal A1, supérieure ou égale à une ou deux fois la longueur de la portion centrale 20. Ainsi, la déformation moyenne d'un bras tenseur, c'est-à-dire le champ de déformation intégré dans le volume du bras tenseur, présente une valeur négligeable vis-à-vis de la déformation moyenne de la portion centrale 20.

Les bras tenseurs 30 peuvent présenter une forme dans le plan XY sensiblement rectangulaire, avec une augmentation brusque de sa largeur à partir de la portion centrale 20, voire une forme de trapèze avec une largeur qui augmente continûment à mesure que l'on s'éloigne de la portion centrale 20. D'autres formes sont bien entendu possibles.

La structuration de la membrane suspendue (partie structurée 11), et notamment le dimensionnement des bras tenseurs 30 vis-à-vis de la portion centrale 20, peut avoir été réalisée de manière à contrôler la valeur de l'amplification de la contrainte en tension de la portion centrale 20, obtenue lors de la réalisation de la cavité et donc de la suspension de la membrane. Pour cela, on prédétermine les paramètres dimensionnels de la partie structurée 11, par exemple les largeurs et longueurs de la portion centrale 20 et des bras tenseurs 30. A titre d'exemple, dans le cas d'une portion centrale 20 rectangulaire, de longueur A et de largeur constante a, et des bras tenseurs 30 rectangulaires de longueur B/2-A/2 et de largeur constante b, un facteur d'amplification f reliant la contrainte finale $\sigma^f$ en tension de la portion centrale 20 à la contrainte initiale $\sigma^i$ en tension peut s'exprimer par la relation suivante formulée dans l'article de Süess et al. intitulé Analysis of enhanced light emission from highly strained germanium microbridges, Nature Photon. 7, 466-472 (2013) :

$$f = \frac{2L + B}{B}\left(1 + \frac{A}{B - A}\right)\Big/\left(\frac{a}{b} + \frac{A}{B - A}\right)$$

où L est la longueur de la partie structurée 11 suspendue. Ainsi, en fonction des paramètres dimensionnels de la partie structurée 11 de la couche semiconductrice 10, on est en mesure de contrôler la valeur de l'amplification de la contrainte en tension appliquée à la portion centrale 20 lors de la réalisation de la cavité. Le facteur d'amplification peut également être estimé au moyen d'un logiciel de simulation numérique tel que COMSOL Multiphysics.

Le dispositif optoélectronique 1 comporte en outre des deuxièmes portions latérales, formant des bras de polarisation 40, adaptés à appliquer une polarisation électrique à la zone active de la portion centrale 20 suivant l'axe longitudinal A1, de préférence une polarisation électrique sensiblement homogène suivant l'axe A1, tout en autorisant une mise en tension efficace de la portion centrale 20 par les bras tenseurs 30.

Pour cela, au moins deux bras de polarisation 40 sont disposés de part et d'autre de la portion centrale 20, de manière opposée l'un à l'autre suivant un axe transversal A2, cet axe A2 étant contenu dans le plan XY et orthogonal à l'axe longitudinal A1. Ils s'étendent donc à partir des bordures latérales de la portion centrale 20 suivant l'axe transversal A2. Dans ce mode de réalisation où la partie structurée 11 est une membrane suspendue, les bras de polarisation 40 participent, avec les bras tenseurs 30, à relier la portion centrale 20 à la partie périphérique 12.

Les bras de polarisation 40 sont distincts des bras tenseurs 30 dans le plan XY. Autrement dit, les bras de polarisation 40 sont espacés d'une distance non nulle vis-à-vis des bras tenseurs 30 suivant l'axe longitudinal A1.

Par ailleurs, chacun des bras de polarisation 40 comporte une partie principale 41 et une pluralité de parties de raccord 42, celles-ci assurant la liaison mécanique et électrique entre la partie principale 41 et la portion centrale 20.

La partie principale 41 présente alors une largeur supérieure à celle de chaque partie de raccord 42. La largeur de la partie principale 41 est ici sa dimension dans le plan XY et suivant l'axe A1. De préférence, pour assurer une polarisation électrique sensiblement homogène de la portion centrale 20 suivant l'axe longitudinal A1, la partie principale 41 de chaque bras de polarisation 40 présente une largeur au moins égale à la longueur de la zone active de la portion centrale 20. De plus, les parties de raccord 42 sont distribuées suivant l'axe A1 de sorte que la polarisation électrique au sein de la zone active est sensiblement homogène suivant l'axe de sa longueur.

La partie principale 41 de chaque bras de polarisation 40 permet de polariser électriquement la zone active de la portion centrale 20 à partir d'un plot de connexion 6. Elle autorise donc le déplacement des porteurs de charge entre la portion centrale 20 et un plot de connexion 6. Elle est donc en contact électrique avec le plot de connexion 6. Celui-ci peut reposer sur et être au contact, au moins partiellement, sur la partie principale 41 du bras de polarisation 40. Les parties principales 41 sont réalisées en un matériau semiconducteur dopé, au moins dans une zone reliant le plot de connexion 6 et les parties de raccord 42, de manière à faciliter le transport des porteurs de charge. Plus précisément, les parties principales 41 des bras de polarisation 40 sont dopées selon des types de conductivité opposés : la partie principale 41 d'un premier bras de polarisation 40 est dopée n+, et celle du second bras de polarisation 40 est dopé p+.

Pour chaque bras de polarisation 40, une pluralité de parties de raccord 42 assure la liaison mécanique et électrique entre la partie principale 41 correspondante et la portion centrale 20. Les parties de raccord 42 s'étendent donc longitudinalement, suivant l'axe A2, à partir d'une bordure latérale de la portion centrale 20, et sont distinctes les unes des autres suivant l'axe A1. A titre illustratif, ils peuvent présenter une longueur de l'ordre de la largeur de la portion centrale 20. Ils sont spatialement distribués suivant l'axe longitudinal A1 de sorte que la polarisation électrique de la zone active est sensiblement homogène. Ils peuvent être dopés du même type de conductivité que celui de la partie principale 41 correspondante, soit sur toute leur longueur, soit sur une partie de leur longueur à partir de la partie principale 41.

Le dispositif optoélectronique 1 comporte également au moins deux plots de connexion 6, qui permettent d'appliquer une polarisation électrique à la zone active de la portion centrale 20, par exemple en direct dans le cas d'une diode laser ou d'une diode électroluminescente, ou en inverse dans le cas d'une photodiode. Pour cela, chaque plot de connexion 6 est en contact électrique avec une partie principale 41 d'un bras de polarisation 40, et peut reposer, au moins partiellement, sur et au contact de la partie principale 41.

De préférence, pour améliorer la qualité de la polarisation électrique de la zone active, les plots de connexion 6 sont partiellement chacun entourés par une ligne d'isolation électrique (non représentée). Une ligne d'isolation s'étend autour d'un plot de connexion 6 entre celui-ci et la partie périphérique 12, et ne s'étend pas entre celui-ci et le bras de polarisation 40. Les lignes d'isolation peuvent être des tranchées traversantes de la couche semiconductrice 10.

En fonctionnement, l'application aux plots de connexion 6 d'une différence de potentiel en direct (pour une diode laser ou une diode électroluminescente) se traduit par une injection de porteurs de charge dans la zone active de la portion centrale 20, via les parties principales 41 et les parties de raccord 42. La polarisation électrique de la zone active est sensiblement homogène suivant l'axe longitudinal A1, alors que la portion centrale 20 reste effectivement contrainte en tension par les bras tenseurs 30. Dans le cas d'une photodiode, l'application d'une différence de potentiel en inverse permet de collecter les porteurs de charge photogénérés dans la zone active de la portion centrale 20.

Ainsi, le dispositif optoélectronique 1 comporte une zone active située dans une portion centrale 20 allongée mise en tension par les bras tenseurs 30 suivant l'axe longitudinal A1. La structure de bandes d'énergie du matériau semiconducteur de la portion centrale 20 et donc de la zone active est alors rendue avantageusement directe par la mise en tension effectuée par les bras tenseurs 30. Les bras de polarisation 40, distincts des bras tenseurs 30 et orientés suivant l'axe transversal A2, par le fait qu'ils sont formés chacun d'une partie principale 41 et de parties de raccord 42, permettent d'appliquer une polarisation électrique à la zone active de la portion centrale 20 de manière sensiblement homogène suivant l'axe longitudinal A1, tout en autorisant la mise en tension efficace de la portion centrale 20 par les bras tenseurs 30. Autrement dit, la mise en tension uniaxiale de la portion centrale 20 est assurée ici par les bras tenseurs 30 et non pas par les bras de polarisation 40. Dans l'exemple de la fig.2A, une contrainte en tension $\varepsilon_{xx}$ de l'ordre de 1.5% peut être obtenue, avec une contrainte en tension transversale $\varepsilon_{xx}$ quasi nulle. Par ailleurs, la polarisation électrique de la zone active sensiblement homogène peut être obtenue par la pluralité de parties de raccord 42. La longueur de diffusion des porteurs de charge (électrons et trous) peut être prise en compte pour optimiser le dimensionnement. Ainsi, la largeur moyenne de la portion centrale 20 suivant l'axe Y peut être au moins du même ordre de grandeur que la longueur de diffusion des porteurs. Les recombinaisons radiatives ont alors lieu majoritairement au centre de la portion centrale 20, permettant un bon recouvrement par le mode optique guidé. Par ailleurs, la distance entre les parties de raccord 42 suivant l'axe A1 peut être inférieure ou égale à la longueur de diffusion des porteurs, de manière à obtenir une polarisation homogène microscopique (au niveau des parties de raccord 42) et macroscopique (le long de la portion centrale 20). Dans le cas où la distance entre les parties de raccord 42 suivant l'axe A1 est supérieure à la longueur de diffusion des porteurs, une polarisation homogène macroscopique seule (le long de la portion centrale 20) sera obtenue. Quoi qu'il en soit, la longueur de diffusion des porteurs peut être importante dans le germanium, au moins égale à 1mm. Elle dépend bien entendu notamment de la température, de la contrainte en tension, de la qualité cristalline.

De plus, il apparaît que l'impact du type de procédé de fabrication du dispositif optoélectronique 1 mis en œuvre sur les propriétés optiques et/ou électroniques de ce dernier est réduit vis-à-vis de l'exemple du dispositif optoélectronique 1 illustré sur la fig. 1, dans lequel la polarisation électrique de la zone active est effectuée via bras tenseurs 30.

En effet, il apparaît que, lorsque la couche semiconductrice 10 est réalisée par épitaxie (par ex. Ge épitaxié sur Si, ou GeSn épitaxié sur Ge), un fort taux de dislocations peut induire un dopage résiduel au sein de la couche semiconductrice 10, par exemple de type p. Aussi, l'injection ou la collection des porteurs de charge dans ou depuis la portion centrale 20 n'est plus homogène suivant l'axe A1 mais est rendue inhomogène : ainsi, les porteurs de charge sont alors injectés essentiellement dans une zone située à la jonction entre la portion centrale 20 dopée p et le bras tenseur dopé n. Autrement dit, la zone active présente alors des dimensions réduites, et plus précisément une longueur réduite. Cela peut alors se traduire par une dégradation des propriétés optiques et/ou électroniques du dispositif optoélectronique 1 : ainsi, dans le cas d'une diode laser, l'efficacité du pompage électrique peut être dégradée, et dans le cas d'une diode électroluminescente et d'une photodiode, la surface optique émissive/réceptrice peut être fortement réduite.

Au contraire, dans le cas du dispositif optoélectronique 1 selon l'invention, la polarisation électrique de la zone active est effectuée par les bras de polarisation 40 suivant l'axe transversal A2, et non plus par les bras tenseurs 30 suivant l'axe longitudinal A1. Aussi, que la portion centrale 20 présente un dopage résiduel ou non, la polarisation électrique reste sensiblement homogène suivant l'axe longitudinal A1. Aussi, les propriétés optiques et/ou électriques du dispositif optoélectronique 1 selon l'invention sont moins impactées par le type de procédé de fabrication mis en œuvre, mais elles sont de plus optimisées. Le rendement quantique interne est en effet élevé sur une grande partie de la longueur de la portion centrale 20, ce qui permet de maximiser la puissance optique d'émission ou la surface de détection lumineuse, et, de manière équivalente, de maximiser l'efficacité de conversion électrique/optique (*Wall-Plug Efficiency,* en anglais). Autrement dit, pour une différence de potentiel appliquée à la zone active de la portion centrale 20, la puissance optique d'émission ou la surface de détection lumineuse est optimisée. De plus, dans le cas d'une source laser, le fait de dissocier l'axe optique de la cavité laser (axe A1) de l'axe électrique de polarisation (axe A2) permet de réduire les pertes optiques intra-cavité. En effet, les bras tenseurs 30, qui peuvent comporter des réflecteurs optiques 5, sont avantageusement réalisés en un matériau semiconducteur intrinsèque (non intentionnellement dopé), et non pas en un matériau (fortement) dopé, réduisant ainsi les pertes optiques.

A ce titre, le dispositif optoélectronique 1 illustré sur les fig.2A à 2C est adapté à émettre un rayonnement lumineux cohérent. La cavité laser de cette diode laser est orientée suivant l'axe longitudinal A1 de la portion centrale 20 allongée. Pour cela, des réflecteurs optiques 5, par exemple des miroirs de Bragg, sont disposés dans les bras tenseurs 30 de part et d'autre de la portion centrale 20. La zone active forme le milieu à gain de la diode laser, qui est situé dans la portion centrale 20. Celle-ci peut être réalisée à base de germanium intrinsèque, par exemple en GeSn. Le pompage électrique du milieu à gain est effectué par les bras de polarisation 40, comme décrit précédemment, lesquels sont dopés n+ et p+. Ainsi, par l'application d'une différence de potentiel à la zone active par les plots de connexion 6 et via des bras de polarisation 40, le pompage électrique du milieu à gain est effectué, qui se traduit par l'émission cohérente du rayonnement lumineux. Dans cet exemple, les réflecteurs optiques 5 sont des miroirs de Bragg, mais il peut également s'agir de structures en coin de cube comme décrit notamment dans l'article de Zabel et al. intitulé Top-down method to introduce ultra-high elastic strain, J. Mater. Res., 2017, 32 (4), 726-736. Par ailleurs, le matériau des bras tenseurs 30 est avantageusement intrinsèque, de manière à limiter les pertes optiques internes à la cavité optique.

La figure 3A et 3B sont des vues en perspective, schématiques et partielles, respectivement d'un dispositif optoélectronique 1 selon un exemple de l'art antérieur (donc ne comportant pas de bras de polarisation 40), et d'un dispositif optoélectronique 1 selon un mode de réalisation (donc comportant des bras de polarisation 40). De plus, la figure 3C illustre l'évolution de la contrainte mécanique $\varepsilon_{xx}$ suivant l'axe longitudinal A1 passant par le centre de la portion centrale 20 suivant l'axe Y, pour ces deux configurations. Par ailleurs, la partie structurée 11 de ces dispositifs optoélectroniques est une membrane suspendue au-dessus d'une couche support 2.

En référence à la fig.3A, le dispositif optoélectronique 1 selon l'art antérieur comporte une zone active dans la portion centrale 20 polarisée électriquement via les bras tenseurs 30. Ces derniers sont dopés selon des types de conductivité opposés de manière à assurer la connexion électrique avec des plots de connexion (non représentés). Ainsi, les bras tenseurs 30 assurent une fonction mécanique de mise en tension de la portion centrale 20, ainsi qu'une fonction électrique de polarisation de la zone active. Dans cet exemple, la couche semiconductrice 10 est réalisée en un même matériau semiconducteur, ici en germanium. La portion centrale 20 présente une longueur suivant l'axe X égale à 10 µm environ et une largeur suivant l'axe Y égale à 1.5 µm environ. La longueur peut être plus importante, par exemple de l'ordre de 20 µm, notamment lorsque la densité de dislocations est faible. Par ailleurs, la largeur peut être de l'ordre de 1 à 2 µm pour obtenir un bon recouvrement des modes optiques tout en autorisant une déformation en tension importante. Les bras tenseurs 30 présentent ici une forme rectangulaire dans le plan XY, avec une longueur de 800 µm environ pour obtenir une tension de 5.5% environ dans le cas du Ge (dans le cas du GeSn, une longueur de 60 µm permet d'obtenir une tension de 1.4% environ) et une largeur égale à 50 µm environ.

En référence à la fig.3B, le dispositif optoélectronique 1 selon ce mode de réalisation comporte des bras de polarisation 40 distincts des bras tenseurs 30, qui assurent la polarisation électrique de la zone active de la portion centrale 20. Ils sont reliés aux bordures latérales de la portion centrale 20, et sont formés chacun d'une partie principale 41 et d'une pluralité de parties de raccord 42. Des plots de connexion (non représentés) sont donc en contact électrique avec les parties principales 41. Le matériau semiconducteur dans les bras tenseurs 30 peut alors être intrinsèque. Dans cet exemple, la couche semiconductrice 10 est également réalisée en germanium ; la portion centrale 20 présente des dimensions identiques à celles du dispositif de la fig.3A, et les dimensions des bras tenseurs 30 sont, elles, sensiblement identiques : la longueur est ici 9% plus grande que celle des bras tenseurs 30 de la fig.3A. Les bras de polarisation 40 comportent chacun une partie principale 41 de forme rectangulaire de longueur suivant l'axe Y égale à $30\mu m$ environ et de largeur suivant l'axe X égale à $8\mu m$ environ, et des parties de raccord 42 de forme rectangulaire de longueur égale à $1.5\mu m$ environ et de largeur égale à 500nm environ. Dans cet exemple, chaque bras de polarisation 40 comporte sept parties de raccord 42 qui sont espacés deux à deux d'une distance suivant l'axe X égale à $1\mu m$ environ. Par ailleurs, chaque bras de polarisation 40 est espacé des bras tenseurs 30 d'une distance suivant l'axe X égale à $2\mu m$ environ.

Comme l'illustre la figure 3C, dans le cas du dispositif optoélectronique 1 de la fig.3A (sans bras de polarisation 40), la contrainte en tension $\varepsilon_{xx}$ dans la portion centrale 20 (trait pointillé) présente une valeur maximale de l'ordre de 1.4% environ et une valeur moyenne de l'ordre de 1.35% environ. Par ailleurs, dans le cas du dispositif optoélectronique 1 de la fig.3B (avec bras de polarisation 40), la contrainte en tension $\varepsilon_{xx}$ (trait continu) présente une valeur maximale également de l'ordre de 1.4% environ et une valeur moyenne de l'ordre de 1.3% environ. Ainsi, il apparaît que le dispositif optoélectronique 1 selon le mode de réalisation présente une mise en tension efficace de la portion centrale 20 par les bras tenseurs 30. Les bras de polarisation 40, par leur structure formée de la partie principale 41 et des parties de raccord 42, permettent de polariser électriquement la zone active, sans impacter sensiblement la contrainte en tension $\varepsilon_{xx}$ subie par la portion centrale 20. De plus, l'agencement des parties de raccord 42 le long des bordures latérales de la portion centrale 20 permet de polariser la zone active de manière sensiblement homogène suivant l'axe longitudinal A1. Les propriétés optiques et/ou électroniques du dispositif optoélectronique 1 selon le mode de réalisation de la fig.4B sont donc améliorées par rapport au dispositif optoélectronique 1 de la fig.4A.

La figure 4A et 4B sont des vues de dessus, schématiques et partielles, de dispositifs optoélectroniques selon des modes de réalisation dans lesquels ils sont adaptés à émettre un rayonnement lumineux cohérent. Ils ne diffèrent du dispositif optoélectronique 1 illustré sur la fig.2A essentiellement en ce que les parties de raccord 42 présentent, outre leur fonction de liaison mécanique et électrique, une fonction supplémentaire de réflecteurs optiques 5 permettant de définir la cavité optique de la diode laser. Dans ces exemples, la partie structurée 11 de la couche semiconductrice 10 forme une membrane suspendue au-dessus d'une couche support 2, mais peut en variante être au contact de cette dernière.

Pour cela, les parties de raccord 42 présentent un agencement suivant l'axe longitudinal A1 et un dimensionnement tels qu'ils forment des réflecteurs optiques 5 vis-à-vis du mode optique supporté par la portion centrale 20. Différents types de cavités optiques sont possibles, par exemple des cavités optiques de type DFB (pour *Distributed Feedback Laser,* en anglais) ou de type DBR (pour *Distributed Bragg Reflector,* en anglais), voire de type *Band-Edge.* D'une manière générale, les parties de raccord 42 des bras de polarisation 40 sont dimensionnées et agencées de manière symétrique de part et d'autre de la portion centrale 20. Le dimensionnement des parties de raccord 42 peut être choisi à partir de diagrammes de bandes de cristaux photoniques unidimensionnels, qui expriment la relation de dispersion du mode optique supporté par la portion centrale 20, et dépendent notamment de caractéristiques de la structure périodique que forment les parties de raccord 42, à savoir le taux de remplissage (rapport de la largeur d'un raccord sur la période de la structure périodique) et la période de la structure périodique adimensionnée par la longueur d'onde du mode optique confiné.

Dans l'exemple de la fig.4A, les parties de raccord 42 des bras de polarisation 40 définissent une cavité optique de type DFB. Les parties de raccord 42 s'étendent ainsi le long de l'axe longitudinal de manière périodique, pour ainsi former un réflecteur distribué suivant toute la longueur de la zone active. Un défaut de période est présent au centre de la structure périodique, de manière à induire un décalage de phase et donc à former une cavité en $\lambda/4$, où $\lambda$ est la longueur d'onde d'émission de la source laser. A titre d'exemple, pour une portion centrale 20 d'une longueur de $20\mu m$ environ et d'une largeur de $2\mu m$ environ, une structure périodique formée par les parties de raccord 42, et présentant un taux de remplissage de 50% pour une période adimensionnée $p/\lambda$ égale, par exemple, à 0.16 ou à 0.3 pour une polarisation des modes de propagation quasi-TE, permet d'obtenir une cavité optique de type DFB.

Dans l'exemple de la fig.4B, les parties de raccord 42 des bras de polarisation 40 définissent une cavité optique de type DBR. Les parties de raccord 42 s'étendent ainsi le long de l'axe longitudinal, dont le dimensionnement est choisi de manière à définir trois zones distinctes : dans des zones d'extrémité 45e, les parties de raccord 42 sont dimensionnées de manière à former des réflecteurs optiques 5 de type miroir de Bragg ; et dans une zone centrale 45c, les parties de raccord 42 sont dimensionnées de manière à minimiser toute influence sur le mode optique confiné. Comme précédemment, le dimensionnement des parties de raccord 42 dans les différentes zones 45c, 45e est obtenu à partir des diagrammes de bandes. A titre d'exemple, pour une portion centrale 20 d'une longueur de $20\mu m$ environ et d'une largeur de $2\mu m$ environ, et pour un taux de remplissage de 20%, une période adimensionnée p/λ égale à 0.4 environ ou également à 0.6 pour des modes de propagation quasi-TE permet d'obtenir des miroirs de Bragg dans les zones d'extrémité 45e, et une période adimensionnée p/λ égale à 0.15 dans la zone centrale 45c permet de limiter toute perturbation optique des parties de raccord 42 situées dans cette zone 45c sur le mode optique confiné.

Par ailleurs, d'autres types de cavités optiques peuvent être formés en fonction du dimensionnement des parties de raccord 42 et de leur agencement suivant l'axe longitudinal A1. A titre d'exemple, une cavité optique du type *Band-Edge* peut être formée, dans laquelle les parties de raccord 42 présentent un dimensionnement et un agencement suivant l'axe A1 tels que la vitesse de groupe du mode optique est annulée dans des zones d'extrémité similaires à celles de la fig.4B. Un exemple de ce type de cavité optique est notamment décrit dans le document Reboud et al., Applied Physics Letters, Lasing in nanoimprinted two-dimensional photonic crystal band-edge lasers, 102, 7, 073101 (2013).

Ainsi, dans un dispositif optoélectronique 1 selon ce mode de réalisation dans lequel la cavité optique est formée par les parties de raccord 42, les bras tenseurs 30 ne comportent avantageusement pas de réflecteurs optiques 5 de type miroirs de Bragg ou coins de cube. On évite ainsi une éventuelle dégradation de la mise en tension de la portion centrale 20 par les bras tenseurs 30, cette dégradation pouvant provenir de la présence des réflecteurs optiques 5 dans les bras tenseurs 30. Le procédé de fabrication en est alors simplifié dans la mesure où il ne comporte pas d'étapes spécifiques de réalisation des réflecteurs optiques 5 dans les bras tenseurs 30. De plus, les pertes optiques, liées à une éventuelle diffusion optique lors du transfert du mode optique entre la portion centrale 20 et les bras tenseurs 30, sont réduites voire écartées.

Les figures 5A et 5B sont des vues de dessus, schématiques et partielles, de dispositifs optoélectroniques selon des modes de réalisation qui diffèrent entre eux essentiellement par la forme de la jonction, courbée ou non, entre les parties de raccord 42 et la portion centrale 20. Dans ces exemples, la partie structurée 11 de la couche semiconductrice 10 forme une membrane suspendue au-dessus d'une couche support 2, mais peut en variante être au contact de cette dernière.

Dans l'exemple de la fig.5A, le dispositif optoélectronique 1 est similaire à celui illustré sur la fig.3B. La couche semiconductrice 10 est réalisée en un même matériau semiconducteur, ici en germanium-étain GeSn, et présente une épaisseur de 1μm environ. La portion centrale 20 présente une forme rectangulaire, de longueur égale à 20μm environ et de largeur égale à 2μm environ. Les bras tenseurs 30 sont de forme rectangulaire, de longueur égale à 50μm environ et de largeur égale à 20μm environ. Chaque bras de polarisation 40 présente une partie principale 41 de forme rectangulaire de longueur égale à 30 μm et de largeur égale à 8 μm et des

parties de raccord 42 de forme rectangulaire de longueur égale à 1.5 μm et de largeur égale à 650 nm. Dans cet exemple, chaque bras de polarisation 40 comporte six parties de raccord 42 qui sont espacées deux à deux d'une distance, suivant l'axe X, égale à 650 nm environ. Par ailleurs, chaque bras de polarisation 40 est espacé des bras tenseurs 30 d'une distance suivant l'axe X égale à 2 μm environ. Dans cet exemple, la jonction 46 entre chaque partie de raccord 42 et la portion centrale 20 n'est pas courbée, mais est sensiblement orthogonale, aux incertitudes technologiques près. Notons à cet égard que les géométries représentées ici sont schématiques : dans la réalité, les jonctions 46 « orthogonales » seront légèrement arrondies, mais elles restent « non courbées », selon la définition donnée ci-après.

Dans l'exemple de la fig.5B, le dispositif optoélectronique 1 est similaire à celui illustré sur la fig.5A, et s'en distingue essentiellement par la forme de la jonction 46 entre les parties de raccord 42 et la portion centrale 20. Les jonctions 46 sont ici courbées, dans le sens où elles présentent une courbure dont le rayon est égal à la moitié de la distance qui sépare deux parties de raccord 42 adjacentes suivant l'axe X, à 25% près. Les raccords présentent avantageusement des jonctions courbées également avec la partie principale 41 des bras de polarisation 40. Ainsi, les ouvertures qui séparent deux parties de raccord 42 adjacentes présentent ici une forme rectangulaire aux extrémités arrondies en arc de cercle.

La figure 5C illustre l'évolution de la contrainte mécanique $\varepsilon_{xx}$ suivant l'axe longitudinal A1 passant à une distance de 100nm d'une bordure latérale de la portion centrale 20 suivant l'axe Y, dans le cas des deux exemples ci-dessus. Il en ressort que, pour la configuration à jonctions orthogonales (fig.5A), la contrainte en tension $\varepsilon_{xx}$ présente de fortes oscillations longitudinales (cf. trait continu sur la fig.5C), dont l'amplitude varie entre 0.25% et 1.2% environ. En revanche, pour la configuration à jonctions courbées (fig.5B), la contrainte en tension $\varepsilon_{xx}$ présente des oscillations longitudinales dont l'amplitude, plus faible, varie ici entre 0.05% et 0.2% environ (cf. trait en pointillé sur la fig.5C). Ainsi, la présence de jonctions courbées entre les parties de raccord 42 et la portion centrale 20 permet d'améliorer la distribution longitudinale des contraintes mécaniques, ce qui se traduit par une meilleure stabilité mécanique de la portion centrale 20, et par une meilleure homogénéité des propriétés optiques et/ou électroniques au sein de la portion centrale 20 et donc au sein de la zone active.

Par ailleurs, comme l'illustrent les fig.5A et 5B, la portion centrale 20 présente avantageusement une jonction 31 avec les bras tenseurs 30 qui présente une courbure en arc de cercle. Le rayon de courbure est au moins égal à la moitié de la largeur locale de la portion centrale 20 au niveau de ses extrémités longitudinales (à proximité des bras tenseurs 30), et de préférence au moins égal à la largeur locale de la portion centrale 20. Ainsi, à titre illustratif, pour une portion centrale 20 d'une largeur locale de 2μm en ses extrémités longitudinales, le rayon de courbure est au moins égal à 1μm et de préférence au moins égal à 2μm. En effet, une jonction 31 orthogonale entre la portion centrale 20 et les bras tenseurs 30, c'est-à-dire à angle droit aux incertitudes technologiques près, peut se traduire par la présence d'un pic de contrainte en tension $\varepsilon_{xx}$ situé aux extrémités longitudinales de la portion centrale 20. Ces pics de contrainte peuvent se traduire par la formation d'une barrière de potentiel qui induit un piégeage local des porteurs de charge. Aussi, les jonctions 31 courbes en arc de cercle permettent d'améliorer l'homogénéité de la distribution spatiale des contraintes en tension, et ainsi de réduire voire d'écarter les risques de formation des zones de concentration des contraintes mécaniques. Ainsi, on réduit les risques de piégeage local des porteurs de charge et on améliore l'homogénéité des propriétés optiques et/ou électriques de la portion centrale 20 et donc de la zone active.

Les figures 6A et 6B sont des vues schématiques et partielles de dispositifs optoélectroniques selon des modes de réalisation, respectivement en vue de dessus et en perspective. Dans ces exemples, les bras de polarisation 40 sont adaptés, en outre, à induire dans la portion centrale 20 une contrainte en tension suivant l'axe transversal A2. La portion centrale 20 est alors contrainte en tension de manière biaxiale, c'est-à-dire suivant l'axe longitudinal A1 et suivant l'axe transversal A2. Par ailleurs, la partie structurée 11 de la couche semiconductrice 10 est ici une membrane suspendue au-dessus de la couche support 2, mais peut en variante être au contact de cette dernière.

Pour être en mesure de contraindre en tension la portion centrale 20 suivant l'axe transversal A2, les bras de polarisation 40 comportent chacun au moins une partie intermédiaire 43 reliant la partie principale 41 et la pluralité de parties de raccord 42. Une partie continue 44 assure alors la liaison mécanique (et électrique) entre la ou les parties intermédiaires 43 et les parties de raccord 42. Une contrainte en tension $\varepsilon_{xx}$ de 1.5% suivant l'axe A1 peut être obtenue, avec une contrainte en tension $\varepsilon_{yy}$ de 1.5% suivant l'axe A2.

Plus précisément, chaque bras de polarisation 40 comporte une partie continue 44 qui s'étend longitudinalement suivant l'axe longitudinal A1, et relie les extrémités des parties de raccord 42 opposées à la portion centrale 20. La partie continue 44 peut présenter une longueur suivant l'axe longitudinal A1 qui peut être égale à la largeur de la partie principale 41 correspondante, et une largeur suivant l'axe transversal A2 inférieure ou égale à la longueur des parties de raccord 42 de manière à améliorer la conduction électrique. La partie continue 44 est de préférence dopée selon le même type de conductivité que celui de la partie principale 41 correspondante.

Par ailleurs, la ou les parties intermédiaires 43 de chaque bras de polarisation 40 s'étendent longitudinalement suivant l'axe transversal A2, et relient la partie continue 44 à la partie principale 41. Pour assurer la mise en tension de la portion centrale 20 vis-à-vis de l'axe transversal A2, les parties intermédiaires 43 présentent des dimensions en longueur et en largeur qui dépendent principalement de celles des parties principales 41 (rapport entre les dimensions des parties 43 vis-à-vis de celles des parties 41). Ainsi, elles présentent chacune une longueur et une largeur inférieures à celles des parties principales 41. Ces valeurs peuvent être estimées au moyen d'un logiciel de simulation numérique tel que COMSOL Multiphysics, en fonction de la valeur désirée du facteur d'amplification de contrainte suivant l'axe A2 au sein de la portion centrale 20. Ainsi, lors de la suspension de la partie structurée 11, la valeur initiale de la contrainte en tension $(\sigma^i)_{A2}$ suivant l'axe A2 subie par la portion centrale 20 est augmentée par les bras de polarisation 40. Le facteur d'amplification reliant la contrainte en tension finale $(\sigma^f)_{A2}$ à la contrainte en tension initiale $(\sigma^i)_{A2}$ peut s'exprimer par une relation similaire à celle de l'article de Süess et al. 2013 indiqué précédemment.

Les bras de polarisation 40 comportent de préférence un même nombre de parties intermédiaires 43, lesquelles sont alors réparties et dimensionnées de manière symétrique vis-à-vis de l'axe longitudinal A1, ceci pour assurer une meilleure stabilité mécanique de la portion centrale 20, ainsi qu'une meilleure homogénéité de la contrainte en tension suivant l'axe transversal A2 au sein de la portion centrale 20.

A titre illustratif, la fig.6A illustre un exemple de dispositif optoélectronique 1 dans lequel chaque bras de polarisation 40 comporte une unique partie intermédiaire 43. Ceux-ci sont alors agencés suivant l'axe transversal A2 passant par le centre de la portion centrale 20. Dans l'exemple de la fig.6B, chaque bras de polarisation 40 comporte trois parties intermédiaires 43, de dimensions identiques et agencées suivant l'axe A1 de manière à améliorer l'homogénéisation de la contrainte en tension subie par la portion centrale 20.

De manière à améliorer l'injection ou la collection des porteurs de charge, la ou les parties intermédiaires 43 ainsi que les parties continues 44 sont réalisées en un matériau semiconducteur dopé. Le niveau de dopage est choisi de manière à réduire la résistance électrique et ainsi faciliter le transport des porteurs de charge. Les parties de raccord 42 peuvent également être dopées, avec un niveau de dopage similaire, au moins à partir de la partie continue 44 correspondante.

Ainsi, la portion centrale 20 subit ici une contrainte en tension biaxiale suivant l'axe longitudinal A1 (par les bras tenseurs 30) et suivant l'axe transversal A2 (par les bras de polarisation 40). Les bras de polarisation 40 présentent donc une fonction électrique de polarisation de la zone active au sein de la portion centrale 20, et une fonction mécanique de mise en tension de la portion centrale 20 suivant l'axe transversal A2. La contrainte en tension subie par la portion centrale 20, nécessaire pour obtenir une structure de bandes directe, peut alors avoir une valeur inférieure à ce qui est requis dans le cas de la contrainte en tension uniaxiale. Notons que le dispositif optoélectronique 1 selon ce mode de réalisation présente une configuration différente de celle décrite notamment dans le document EP2960203 où la portion centrale 20 présente un rapport de forme longueur/largeur sensiblement égal à l'unité. En effet, ici, la portion centrale 20 est allongée, ce qui permet d'obtenir des propriétés optiques et/ou électroniques améliorées, et notamment une puissance optique plus importante.

Comme mentionné précédemment, la partie structurée 11 de la couche semiconductrice 10 peut être une membrane suspendue au-dessus d'une couche support 2, ou peut être au contact de la couche support 2. Le dispositif optoélectronique 1 peut être obtenu par un procédé de fabrication similaire à celui décrit dans le brevet européen EP3151265.

La couche semiconductrice 10 est dopée de manière localisée, plus précisément dans les bras de polarisation 40, et en particulier dans les parties principales 41 et éventuellement dans les parties de raccord 42, par exemple après croissance par implantation d'éléments dopants suivie d'un recuit d'activation des dopants. La couche semiconductrice 10 reste avantageusement intrinsèque dans les bras tenseurs 30.

Puis, après ou simultanément à la formation de la membrane suspendue, la partie structurée 11 peut être mise en contact avec la couche support 2. La solidarisation de la partie structurée 11 à la couche support 2 peut être effectuée par collage moléculaire hydrophile ou hydrophobe. Ainsi, après suspension de la partie structurée 11 au-dessus de la couche support 2, la mise en contact peut être effectuée par immersion de la partie structurée 11 dans une solution liquide, suivie de l'évaporation du liquide, de sorte que la partie structurée 11 vienne alors naturellement au contact de la couche support 2. Le collage moléculaire est de type hydrophobe lorsque les surfaces sont solidarisées l'une à l'autre par l'intermédiaire de liaisons hydrogène. C'est le cas notamment lorsque la couche semiconductrice 10 est réalisée à base de germanium et que la couche support 2 est en silicium. En variante, la mise en contact de la partie structurée 11 sur la couche support 2 peut être obtenue lors de la formation de la cavité, par gravure humide par HF vapeur en haute pression ou par HF liquide. A noter qu'il est avantageux que la face supérieure de la couche support 2 soit formée d'une sous-couche en un matériau diélectrique, par exemple du SiN ou du $HfO_2$, qui soit inerte à l'agent de gravure (HF) utilisé lors de la mise en contact de la partie centrale 20 sur la couche support 2.

La partie structurée 11 peut ensuite être séparée de la partie périphérique 12. De préférence, pour améliorer la tenue mécanique de la partie structurée 11, et plus précisément pour augmenter l'énergie de collage associée aux surfaces en contact vis-à-vis de l'énergie élastique associée aux bras tenseurs 30 et aux bras de polarisation 40, un recuit de consolidation est avantageusement effectué. Ensuite, on peut retirer, par gravure localisée, une portion distale des bras tenseurs 30 et des bras de polarisation 40. La portion distale est une portion des bras éloignée de la portion centrale 20 et assurant la jonction mécanique avec la partie périphérique 12. Notons que la partie périphérique 12 peut également être entièrement supprimée.

En variante, la solidarisation de la partie structurée 11 à la couche support 2 peut être effectuée par collage moléculaire hydrophile. Dans ce cas, une couche mince d'un matériau intercalaire, obtenu par dépôt ou par oxydation, peut alors être présent entre la couche support 2 et la couche semiconductrice 10. Le matériau intercalaire peut être un oxyde ou un nitrure. Cette couche mince intercalaire peut participer à assurer l'isolation électrique entre la partie structurée 11 et la couche support 2. Par ailleurs, le collage moléculaire hydrophile présente l'avantage d'avoir une énergie de collage supérieure à celle du collage hydrophobe jusqu'à des températures de recuit de l'ordre de 500°C à 600°C (dans le cas du GeSn, la température de recuit peut être de préférence est au plus de 300°C).

Les figures 7A à 7C illustrent différents dispositifs optoélectroniques selon des variantes de réalisation.

La figure 7A est une vue de dessus, schématique et partielle, d'un dispositif optoélectronique 1 similaire à celui illustré sur la fig.2A, dans lequel la partie structurée 11 est non plus une membrane suspendue, mais est au contact de la couche support 2. Les bras tenseurs 30 et les bras de polarisation 40 sont donc distincts, dans le plan XY, de la partie périphérique 12. La portion centrale 20 repose alors sur la couche support 2, qui peut comporter un guide d'onde situé sous la portion centrale 20 et en couplage optique par onde évanescente avec celle-ci. Dans le cas d'un collage moléculaire hydrophile, une couche en un oxyde de silicium peut être située à l'interface entre la couche support 2 et la couche semiconductrice 10, qui participe alors à l'isolation électrique entre ces éléments sans pour autant perturber leur couplage optique

Les figures 7B et 7C sont des vues en coupe suivant l'axe transversal A2, schématiques et partielles, de dispositifs optoélectroniques similaires à celui illustré sur la fig.2A, dans lesquels la couche semiconductrice 10 comporte une sous-couche 10.1 de germanium issue d'un substrat GeOI. La couche sacrificielle 3 est alors réalisée en un oxyde de silicium et la couche support 2 est en silicium. Par ailleurs, la partie structurée 11 de la couche semiconductrice 10 est une membrane suspendue au-dessus de la couche support 2.

Dans l'exemple de la fig.7B, la couche semiconductrice 10 comporte une sous-couche supérieure 10.2 réalisée à base de GeSn, qui recouvre continûment une sous-couche inférieure 10.1 de Ge. La sous-couche inférieure 10.1 peut être réalisée en Ge intrinsèque, et la sous-couche supérieure 10.2 à base de GeSn peut être dopée au niveau des parties principales 41 des bras de polarisation 40, et éventuellement au niveau des parties de raccord 42. Elle est de préférence non intentionnellement dopée au niveau de la portion centrale 20. Les plots de connexion 6 reposent sur et au contact des zones dopées de la sous-couche supérieure 10.2 à base de GeSn. En variante, la sous-couche inférieure 10.1 en Ge peut être gravée localement, au moins au niveau de la portion centrale 20, par exemple par gravure sélective RIE (*Reactive Ion Etching*) de type ICP (*Inductively Coupled Plasma*) au $CF_4$. En variante encore, un premier plot de connexion 6 peut reposer au contact de la sous-couche 10.2, par exemple sur une partie principale 41, et le deuxième plot de connexion 6 peut reposer au contact de la sous-couche 10.2, par exemple sur une partie principale 41.

Dans l'exemple de la fig.7C, la sous-couche inférieure 10.1 de Ge est dopée au niveau des parties principales 41 des bras de polarisation 40, et éventuellement au niveau des parties de raccord 42. Elle est de préférence non intentionnellement dopée au niveau de la portion centrale 20. La sous-couche supérieure 10.2 à base de GeSn a été gravée localement de sorte qu'elle ne recouvre que la portion centrale 20, les parties de raccord 42 et une zone de la partie principale 41 des bras de polarisation 40. Elle est de préférence non intentionnellement dopée. Aussi, les plots de connexion 6 reposent sur et au contact des zones dopées de la sous-couche inférieure 10.1 en Ge. En variante, la sous-couche inférieure 10.1 en Ge peut être gravée localement au moins au niveau de la portion centrale 20.

En variante, la couche semiconductrice 10 peut ne pas être issue d'un substrat GeOI, mais peut reposer sur un substrat SOI. Aussi, dans le cadre des deux exemples des fig.7B et 7C, la sous-couche de Ge repose sur une couche mince en silicium, laquelle repose sur la couche sacrificielle 3 en un oxyde de silicium. Cette couche mince de silicium peut s'étendre continûment dans la partie structurée 11 de la couche semiconductrice 10, ou peut être gravée localement au moins au niveau de la portion centrale 20.

Des modes de réalisation particuliers viennent d'être décrits. Différentes variantes et modifications apparaîtront à l'homme du métier.

## Revendications

**1.** Dispositif optoélectronique (1), comportant :

○ une couche semiconductrice (10) réalisée à base d'un matériau semiconducteur cristallin, comportant :

• une portion centrale (20),

- présentant une forme allongée suivant un axe longitudinal (A1), de longueur suivant l'axe longitudinal (A1) supérieure à sa largeur moyenne,
- contrainte en tension suivant l'axe longitudinal (A1), et

- comportant une zone active d'émission ou de détection d'un rayonnement lumineux ;

• au moins deux premières portions latérales formant des bras tenseurs (30),

- opposés l'un à l'autre vis-à-vis de la portion centrale (20) suivant l'axe longitudinal (A1), et s'étendant à partir de la portion centrale (20), et
- présentant une largeur moyenne supérieure à la largeur moyenne de la portion centrale (20), de manière à contraindre en tension la portion centrale (20) suivant l'axe longitudinal (A1) ;

○ au moins deux plots de connexion (6), adaptés à appliquer une polarisation électrique à la portion centrale (20) ;

○ dans lequel la couche semiconductrice (10) comporte en outre :

• au moins deux deuxièmes portions latérales formant des bras de polarisation (40),

- opposés l'un à l'autre vis-à-vis de la portion centrale (20) suivant un axe transversal (A2) orienté de manière orthogonale à l'axe longitudinal (A1), et s'étendant à partir de la portion centrale (20), chacun étant formé :

▪ d'une partie principale (41), en contact électrique avec l'un des plots de connexion (6), les parties principales (41) des bras de polarisation (40) étant dopées selon des types de conductivité opposés,
▪ d'une pluralité de parties de raccord (42), distinctes les unes des autres suivant l'axe longitudinal (A1), reliant la partie principale (41) à la portion centrale (20).

**2.** Dispositif optoélectronique (1) selon la revendication 1, dans lequel le matériau semiconducteur cristallin dans les bras tenseurs (30) est intrinsèque.

**3.** Dispositif optoélectronique (1) selon la revendication 1 ou 2, adapté à émettre un rayonnement lumineux à une longueur d'onde À, dans lequel les parties de raccord (42) sont agencées suivant l'axe longitudinal (A1) de manière périodique, la période p de l'agencement des parties de raccord (42) suivant l'axe longitudinal (A1) étant inférieure à la longueur d'onde À.

**4.** Dispositif optoélectronique (1) selon la revendication 3, dans lequel un rapport de la largeur des parties de raccord (42) suivant l'axe longitudinal (A1) sur une distance séparant deux parties de raccord (42) adjacentes suivant l'axe longitudinal (A1), et le rapport de la période p sur la longueur d'onde À, sont tels que les parties de raccord (42) forment des réflecteurs optiques (5) définissant une cavité optique vis-à-vis d'un mode optique de longueur d'onde λ supporté par la portion centrale (20).

**5.** Dispositif optoélectronique (1) selon l'une quelconque des revendications 1 à 4, dans lequel les parties de raccord (42) présentent une jonction courbée avec la portion centrale (20), avec un rayon de courbure égal, à 10% près, à la moitié d'une distance séparant deux parties de raccord (42) adjacentes suivant l'axe longitudinal (A1).

**6.** Dispositif optoélectronique (1) selon l'une quelconque des revendications 1 à 5, dans lequel les bras de polarisation (40) comportent chacun :

○ une partie continue (44), distincte de la portion centrale (20), s'étendant longitudinalement suivant l'axe longitudinal (A1), et reliant les parties de raccord (42) entre elles ; et
○ au moins une partie intermédiaire (43) reliant la partie principale (41) à la partie continue (44), la partie intermédiaire (43) présentant une longueur et une largeur inférieures à celles de la partie principale (41) correspondante, de sorte que les bras de polarisation (40) induisent dans la portion centrale (20) une contrainte en tension orientée suivant l'axe transversal (A2).

**7.** Dispositif optoélectronique (1) selon l'une quelconque des revendications 1 à 6, dans lequel la portion centrale (20) présente une structure de bandes d'énergie directe.

**8.** Dispositif optoélectronique (1) selon l'une quelconque des revendications 1 à 7, dans lequel la couche semiconductrice (10) est réalisée à base de germanium.

**9.** Dispositif optoélectronique (1) selon l'une quelconque des revendications 1 à 8, dans lequel les plots de connexion (6) reposent sur et au contact des parties principales (41) des bras de polarisation (40).

**10.** Dispositif optoélectronique (1) selon l'une quelconque des revendications 1 à 9, dans lequel la couche semiconductrice (10) comporte une partie dite structurée (11) et une partie dite périphérique (12), la partie structurée (11) étant formée de la portion centrale (20), des bras tenseurs (30) et des bras de polarisation (40), la partie structurée (11) étant une membrane suspendue au-dessus d'une couche support (2), ou étant au contact de la couche support (2) et distincte de celle-ci dans un plan parallèle à la couche support (2).

**Patentansprüche**

**1.** Optoelektronische Vorrichtung (1), aufweisend:

○ eine Halbleiterschicht (10), die aus einem kristallinen Halbleitermaterial hergestellt ist, aufweisend:

• einen mittleren Teilbereich (20),

- der eine längliche Form entlang einer Längsachse (A1) aufweist, mit einer Länge entlang der Längsachse (A1), die größer als seine mittlere Breite ist,
- der entlang der Längsachse (A1) spannungsbelastet ist, und
- einen aktiven Bereich zur Abgabe oder Erfassung einer Lichtstrahlung aufweist;

• mindestens zwei erste seitliche Teilbereiche, die Spannarme (30) bilden,

- die gegenüber dem mittleren Teilbereich (20) entlang der Längsachse (A1) einander gegenüberstehen und sich vom mittleren Teilbereich (20) erstrecken, und
- eine mittlere Breite aufweisen, die größer als die mittlere Breite des mittleren Teilbereichs (20) ist, um den mittleren Teilbereich (20) entlang der Längsachse (A1) mit Spannung zu belasten;

○ mindestens zwei Verbindungs-Pads (6), die geeignet sind, eine elektrische Polarisation an den mittleren Teilbereich (20) anzulegen;
○ wobei die Halbleiterschicht (10) ferner Folgendes aufweist:

• mindestens zwei zweite seitliche Teilbereiche, die Polarisationsarme (40) bilden,

- die gegenüber dem mittleren Teilbereich (20) entlang einer Querachse (A2) einander gegenüberstehen, die orthogonal zur Längsachse (A1) orientiert ist, und sich vom mittleren Teilbereich (20) erstrecken, wobei jeder aus Folgendem gebildet ist:

■ einem Hauptabschnitt (41), der mit einem der Verbindungs-Pads (6) in elektrischem Kontakt steht, wobei die Hauptabschnitte (41) der Polarisationsarme (40) gemäß entgegengesetzten Leitfähigkeitsarten dotiert sind,

■ einer Mehrzahl von Anschlussabschnitten (42), die entlang der Längsachse (A1) voneinander ge-sondert sind, die den Hauptab-schnitt (41) mit dem mittleren Teilbereich (20) verbinden.

2. Optoelektronische Vorrichtung (1) nach Anspruch 1, wobei das kristalline Halbleitermaterial in den Spann-narmen (30) eigenleitend ist.

3. Optoelektronische Vorrichtung (1) nach Anspruch 1 oder 2, die geeignet ist, eine Lichtstrahlung auf einer Wellenlänge λ abzugeben, wobei die Anschlussabschnitte (42) periodisch entlang der Längsachse (A1) angeordnet sind, wobei die Periode p der Anordnung der Anschlussabschnitte (42) entlang der Längsachse (A1) kleiner als die Wellenlänge λ ist.

4. Optoelektronische Vorrichtung (1) nach Anspruch 3, wobei ein Verhältnis der Breite der Anschlussabschnitte (42) entlang der Längsachse (A1) zu einem Abstand, der zwei entlang der Längsachse (A1) benachbarte Anschlussabschnitte (42) trennt, und das Verhältnis der Periode p zur Wellenlänge λ so sind, dass die Anschlussabschnitte (42) optische Reflektoren (5) bilden, die einen optischen Resonator gegenüber einer optischen Mode einer Wellenlänge λ definieren, die vom mittleren Teilbereich (20) gestützt wird.

5. Optoelektronische Vorrichtung (1) nach einem der Ansprüche 1 bis 4, wobei die Anschlussabschnitte (42) eine gekrümmte Verbindungsstelle zum mittleren Teilbereich (20) aufweisen, mit einem Krümmungsradius, der auf 10% genau gleich der Hälfte eines Abstands ist, der zwei entlang der Längsachse (A1) benachbarte Anschlussabschnitte (42) trennt.

6. Optoelektronische Vorrichtung (1) nach einem der Ansprüche 1 bis 5, wobei die Polarisationsarme (40) jeweils Folgendes aufweisen:

◦ einen durchgehenden Abschnitt (44), der vom mittleren Teilbereich (20) gesondert ist, der sich entlang der Längsachse (A1) längs erstreckt und die Anschlussabschnitte (42) miteinander verbindet; und
◦ mindestens einen Zwischenabschnitt (43), der den Hauptabschnitt (41) mit dem durchgehenden Abschnitt (44) verbindet, wobei der Zwischenabschnitt (43) eine Länge und eine Breite aufweisen, die kleiner als jene des entsprechenden Hauptabschnitts (41) sind, so dass die Polarisationsarme (40) im mittleren Teilbereich (20) eine Spannungsbelastung hervorrufen, die entlang der Querachse (A2) orientiert ist.

7. Optoelektronische Vorrichtung (1) nach einem der Ansprüche 1 bis 6, wobei der mittlere Teilbereich (20) eine direkte Energiebandstruktur aufweist.

8. Optoelektronische Vorrichtung (1) nach einem der Ansprüche 1 bis 7, wobei die Halbleiterschicht (10) aus Germanium hergestellt ist.

9. Optoelektronische Vorrichtung (1) nach einem der Ansprüche 1 bis 8, wobei die Verbindungs-Pads (6) auf den Hauptabschnitten (41) der Polarisationsarme (40) aufliegen und mit ihnen in Kontakt stehen.

10. Optoelektronische Vorrichtung (1) nach einem der Ansprüche 1 bis 9, wobei die Halbleiterschicht (10) einen strukturierten Abschnitt (11) und einen umlaufenden Abschnitt (12) aufweist, wobei der strukturierte Abschnitt (11) vom mittleren Teilbereich (20), den Spannarmen (30) und den Polarisationsarmen (40) gebildet ist, wobei der strukturierte Abschnitt (11) eine Membran ist, die über einer Trägerschicht (2) aufgehängt ist oder mit der Trägerschicht (2) in Kontakt steht und in einer Ebene parallel zur Trägerschicht (2) von dieser gesondert ist.

**Claims**

1. Optoelectronic device (1), comprising:

◦ a semiconductor layer (10) based on a crystalline semiconductor, comprising:

• a central segment (20),

- which has a shape that is elongate along a longitudinal axis (A1), of length along the longitudinal axis (A1) larger than its average width,
- which is tensilely strained along the longitudinal axis (A1), and
- which comprises an active region for emitting or detecting light radiation;

• at least two first lateral segments forming tensioning arms (30),

- which are opposite one another with respect to the central segment (20) along the longitudinal axis (A1) and extend from the central segment (20), and
- which have an average width larger than the average width of the central segment (20), so as to tensilely strain the central segment (20) along the longitudinal axis (A1);

 ◦ at least two connection pads (6), which are suitable for applying an electrical bias to the central segment (20);
 ◦ wherein the semiconductor layer (10) furthermore comprises:

  • at least two second lateral segments forming biasing arms (40),

  - which are opposite one another with respect to the central segment (20) along a transverse axis (A2) oriented orthogonally to the longitudinal axis (A1) and extend from the central segment (20), each being formed:

   ▪ from a main portion (41), which makes electrical contact with one of the connection pads (6), the main portions (41) of the biasing arms (40) being doped opposite conductivity types,
   ▪ from a plurality of joining portions (42), which are separate from one another along the longitudinal axis (A1) and link the main portion (41) to the central segment (20).

**2.** Optoelectronic device (1) according to Claim 1, wherein the crystalline semiconductor in the tensioning arms (30) is intrinsic.

**3.** Optoelectronic device (1) according to Claim 1 or 2, which device is suitable for emitting light radiation at a wavelength A, wherein the joining portions (42) are arranged along the longitudinal axis (A1) periodically, the period p of the arrangement of the joining portions (42) along the longitudinal axis (A1) being shorter than the wavelength $\lambda$.

**4.** Optoelectronic device (1) according to Claim 3, wherein a ratio of the width of the joining portions (42) along the longitudinal axis (A1) to a distance separating two adjacent joining portions (42) along the longitudinal axis (A1), and the ratio of the period p to the wavelength A, are such that the joining portions (42) form optical reflectors (5) defining an optical cavity with respect to an optical mode of wavelength $\lambda$ supported by the central segment (20).

**5.** Optoelectronic device (1) according to any one of Claims 1 to 4, wherein the joining portions (42) have a curved junction with the central segment (20), with a radius of curvature equal, to within 10%, to half a distance separating two adjacent joining portions (42) along the longitudinal axis (A1).

**6.** Optoelectronic device (1) according to any one of Claims 1 to 5, wherein the biasing arms (40) each comprise:

 ◦ a continuous portion (44), which is separate from the central segment (20), extends longitudinally along the longitudinal axis (A1) and links the joining portions (42) to one another; and
 ◦ at least one intermediate portion (43) linking the main portion (41) to the continuous portion (44), the intermediate portion (43) having a length and a width smaller than those of the corresponding main portion (41), so that the biasing arms (40) induce in the central segment (20) a tensile strain oriented along the transverse axis (A2).

**7.** Optoelectronic device (1) according to any one of Claims 1 to 6, wherein the central segment (20) has a direct electronic band structure.

**8.** Optoelectronic device (1) according to any one of Claims 1 to 7, wherein the semiconductor layer (10) is based on germanium.

**9.** Optoelectronic device (1) according to any one of Claims 1 to 8, wherein the connection pads (6) rest on and in contact with the main portions (41) of the biasing arms (40).

**10.** Optoelectronic device (1) according to any one of Claims 1 to 9, wherein the semiconductor layer (10) comprises a portion called the structured portion (11) and a portion called the peripheral portion (12), the structured portion (11) being formed from the central segment (20), from the tensioning arms (30) and from the biasing arms (40), the structured portion (11) being a membrane that is suspended above a carrier layer (2), or that makes contact with the carrier layer (2) while being distinct therefrom in a plane parallel to the carrier layer (2).

**Fig.1**

**Fig.2A**

**Fig.2B**

**Fig.2C**

**Fig.3A**

**Fig.3B**

**Fig.3C**

**Fig.4A**

**Fig.4B**

**Fig.5A**

**Fig.5B**

**Fig.5C**

**Fig.6A**

**Fig.6B**

**Fig.7A**

**Fig.7B**

**Fig.7C**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 3447549 A1
- WO 2018037189 A
- EP 2960203 A
- EP 3151265 A

**Littérature non-brevet citée dans la description**

- **PETYKIEWICZ et al.** Direct Bandgap Light Emission from Strained Ge Nanowires. *Nano Lett.,* 2016, vol. 16 (4), 2168-2173
- **SÜESS et al.** Analysis of enhanced light emission from highly strained germanium microbridges. *Nature Photon,* 2013, vol. 7, 466-472
- **ZABEL et al.** Top-down method to introduce ultra-high elastic strain. *J. Mater. Res.,* 2017, vol. 32 (4), 726-736
- **REBOUD et al.** Lasing in nanoimprinted two-dimensional photonic crystal band-edge lasers. *Applied Physics Letters,* 2013, vol. 102 (7), 073101